# EUROPEAN PATENT SPECIFICATION

(11) **EP 1 573 745 B1**
(45) Date of publication and mention of the grant of the patent: **01.12.2010**
(21) Application number: 03796820.3
(22) Date of filing: 05.12.2003
(51) Int. Cl.: G11C 16/04, G11C 16/06, H03K 19/173

(54) **PROGRAMMABLE INTERCONNECT CELL FOR CONFIGURING A FIELD PROGRAMMABLE GATE ARRAY**
PROGRAMMIERBARE VERBINDUNGSZELLE ZUM KONFIGURIEREN EINES FPGA
CELLULE D'INTERCONNEXION PROGRAMMABLE PERMETTANT DE CONFIGURER UN RESEAU PREDIFFUSE PROGRAMMABLE PAR L'UTILISATEUR

(30) Priority: 12.12.2002 US 319782
(43) Date of publication of application: 14.09.2005
(73) Proprietor: ACTEL CORPORATION, Mountain View, California 94043-4655 (US)
(72) Inventor: HECHT, Volker, 30890 Barsinghausen (DE); BROZE, Robert, Ullrich, Santa Cruz, CA 95060 (US); PENG, Zhezhong, San Jose, CA 95129 (US)
(74) Representative: Manitz, Finsterwald & Partner GbR
(86) International application number: PCT/US2003/039028
(87) International publication number: WO 2004/055866

(56) References cited:
- US-A- 5 329 487
- US-A- 5 648 669
- US-A- 5 764 096
- US-B1- 6 201 734

## Description

### BACKGROUND OF THE INVENTION

### 1. Field of the Invention

The present invention relates to field programmable gate array (FPGA) integrated circuits. More particularly, the present invention relates to reprogrammable FPGA devices and to programmable interconnect cell devices for configuring a user circuit in a reprogrammable FPGA device.

### 2. The Prior Art

FPGA integrated circuits are known in the art. FPGA devices may be classified in one of two categories. One category of FPGA devices is one-time programmable and uses elements such as antifuse for making programmable connections. The other category of FPGA devices is programmable and uses transistor switches to make programmable connections.

Typically, an FPGA has an array of logic elements and wiring interconnections with many thousand of programmable interconnect cells so that the FPGA can be configured by the user into an integrated circuit with defined functions. Each programmable interconnect cell, or switch, can connect two circuit nodes in the integrated circuit to make or break a wiring interconnection or to set the function or functions of a logic element.

Reprogrammable FPGA devices include some means for storing program information used to control the programmable elements. Non-volatile memory devices such as EPROMs, EEPROMs, non-volatile RAM and flash memory devices have all been proposed for or used to store programming information in reprogrammable FPGA applications.

An ideal memory device optimizes density, preserves critical memory in a nonvolatile condition, is easy to program and reprogram, and is read quickly. Some non-volatile memory devices meet more of the above requirements than others. For instance, EPROMS are high density, however, they have to be exposed to ultra-violet light for erasure. EEPROMS are electrically byte-erasable, but are less reliable and have the lowest density. Flash memory devices, however, are low cost, high density, low power, high-reliability devices resulting in a high-speed architecture.

US 5,764,096 describes a programmable interconnect which closely integrates an independent switching transistor with separate NVM programming and erasing elements. The programming element is an EPROM transistor and the erasing element is a Fowler-Nordheim tunneling device. A unitary floating gate is shared by the switching transistor and the NVM programming elements which charge and discharge the floating gate. The shared floating gate structure is the memory structure of the integrated programmable interconnect and controls the impedance of the switching transistor.

US 6,201,734 B1 describes a programmable impedance element which is implemented using integrated circuit techniques and devices. An impedance of the programmable impedance element is adjusted by appropriately configuring the element. The programmable impedance element has a range of impedance values, and is configurable to be a value within this range. The programmable impedance element can be implemented by use of a floating gate device.

There is a need in the art for a programmable interconnect cell having a memory component that is low cost, has high density, has low power consumption and is highly reliable. There is also a need in the art for an FPGA cell having a switch element and a sense element with the foregoing capabilities.

### BRIEF DESCRIPTION OF THE INVENTION

The present invention comprises a programmable interconnect cell switching circuit structure having a control gate potential node, a first floating gate flash transistor with a drain, a source, a floating gate and a control gate connected to the control gate potential node and a second floating gate flash memory transistor having a drain connected to a first programming node, a drain connected to a second programming node, a floating gate connected to the floating gate of the first floating gate flash transistor and a control gate connected to the control gate potential node, whereby either the source or the drain of the first floating gate flash transistor need to be connected outside the cell to ground during the program operation.

A better understanding of the features and advantages of the present invention will be obtained by reference to the following detailed description of the invention and accompanying drawings, which set forth an illustrative embodiment in which the principles of the invention are utilized.

### BRIEF DESCRIPTION OF THE DRAWINGS

FIG. 1 is a simplified schematic diagram of a programmable interconnect cell of the present invention as used in a field programmable gate array structure.
FIG. 2 is a plan view of the cell structure of the programmable interconnect cell of FIG. 1.
FIG. 3 is a cross-sectional view of the programmable interconnect cell along vertical line of the plan view of FIG. 2.
Fig. 4 is a chart showing the representative potentials that can be applied to the programmable interconnect cell of the present invention for the purpose of erasing, programming, and operating the programmable interconnect cell.

### DETAILED DESCRIPTION OF THE INVENTION

Those of ordinary skill in the art will realize that the following description of the present invention is illustrative only and not in any way limiting. Other embodiments of the invention will readily suggest themselves to such skilled persons.

The present invention discloses a programmable interconnect for use in programmable logic circuits. More specifically, the present invention discloses a programmable interconnect for a field programmable gate arrays (FPGAs). Each of the programmable interconnects may have a switch transistor which has its source/drain connected to a first and second circuit node respectively and a sense transistor which forms the memory element of the cell.

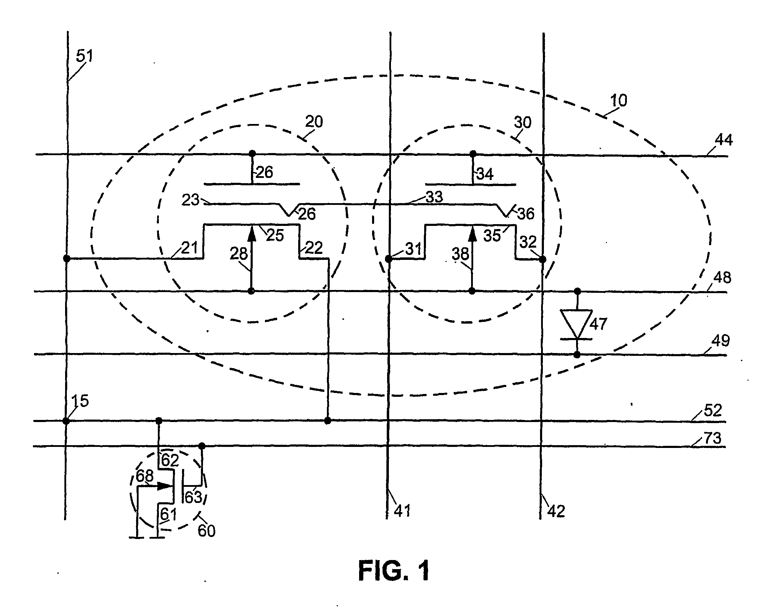

FIG. 1 is a schematic of the programmable interconnect cell 10 of the present invention. Programmable interconnect cell 10 comprises a switch transistor 20 and a sense transistor 30. Switch transistor 20 further comprises a switch source region 21 of the transistor and a switch drain region 22 of the transistor. The programmable interconnect cell 10 makes or breaks a connection at programmable intersection 15 between two routing tracks 51 and 52 through the switch transistor 20, depending on whether switch transistor has been programmed or left unprogrammed according to the requirements of the user circuit. The switch source region 21 is connected to routing track 51 and the switch sense region 22 is connected to the routing track 52. Switch transistor 20 has floating gate 23. Floating gate 23 of switch transistor 20 is connected to the floating gate 33 of sense transistor 30 and will be discussed in greater detail below.

Sense transistor 30 has a source region 31 and a drain region 32. The source 31 of the sense transistor 30 is connected also to a source column line 41, and the drain 32 is connected to a drain column line 42. Column lines 41 and 42 are connected to all source and drain regions of sense transistors 30 in a column. Sense transistor 30 has a floating gate 33. Floating gate 23 of switch transistor 20 and floating gate 33 of sense transistor 30 are connected together.

Switch transistor 20 has a channel region 25. Sense transistor 30 has a channel region 35. There is a Fowler-Nordham tunneling region 26 between the floating gate 23 and channel 25 of the switch transistor 20. There is a Fowler-Nordham tunneling region 36 between the floating gate 33 and channel 35 of the sense transistor 30. Fowler-Nordham tunneling is well known to those of ordinary skill in the art and will not be discussed herein to avoid overcomplicating the disclosure and therefore obscuring the present invention.

Switch transistor control gate 24 and sense transistor control gate 34 are connected to row line 44. Row line 44 connects all control gates 24 and 34 of all cells 10 within a row. Both switch device 20 and sense device 30 are located in a triple p-well 48. Triple p-well 48 is global to all cells 10 within the array. Bulk-connections 28 of all switch transistors 20 and bulk-connections 38 of all sense-transistors 30 are therefore connected to the triple p-well node 48. Triple p-well 48 is located inside an n-well 49, represented in the schematic by a p-well to n-well diode 47.

A grounding transistor 60 has a source region 61, a drain region 62, a gate 63 and a bulk 68. The source region 61 and bulk 68 of this transistor 60 is connected to ground. Gate 63 of transistor 60 is connected to a global erase/program mode signal line 73. The source region 21 of the switch transistor 20 needs to be connected to a drain region 62 of a grounding transistor 60 over routing structure. As shown in Fig. 1, the drain region 62 of the grounding transistor 60 is connected to routing track 52, which connects to drain region 22 of the switch transistor 20 in order to fulfill this requirement. In another embodiment, a drain region 62 of a grounding transistor 60 may be connected to routing track 51.

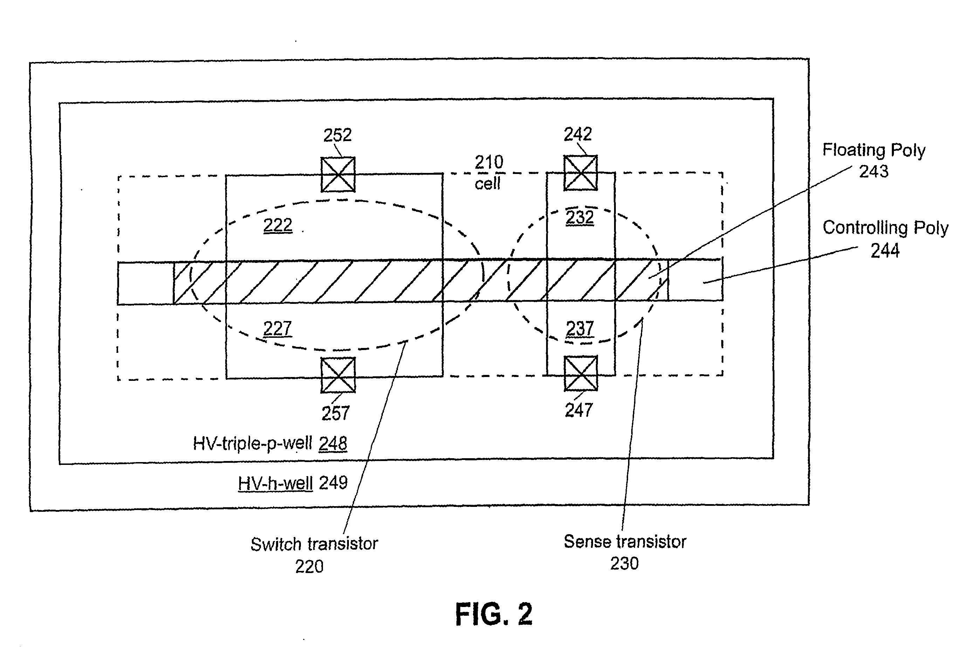

FIG. 2 is a plan view of programmable interconnect element of FIG.1. FIG.2 further illustrates the layout of programmable interconnect cell 210 having switch transistor 220 and sense transistor 230. Polysilicon floating gate 243 covers both transistor 220 and transistor 230 but does not extend to the edge of cell 210, whereas the self aligned polysilicon control gate 244 covers the whole floating gate 243 and extends to the edge of cell 210. Self-aligned polysilicon control gate 244 connects to polysilicon control gates 244 of adjacent cells 210 within the same row.

Contacts 251 and 252, which form the circuit nodes of the user configurable circuit of the FPGA, are provided to the source/drain regions 221 and 222 of switch transistor 220 for contacting the circuit nodes. Contacts 241 and 242, which form the circuit nodes connected to the source/drain region 231 and 232 of the sense transistor 230. Both switch transistors 220 and sense transistors 230 of all cells are located in the same high-voltage triple p-well 248. High-voltage triple p-well 248 is located inside a high-voltage n-well 249.

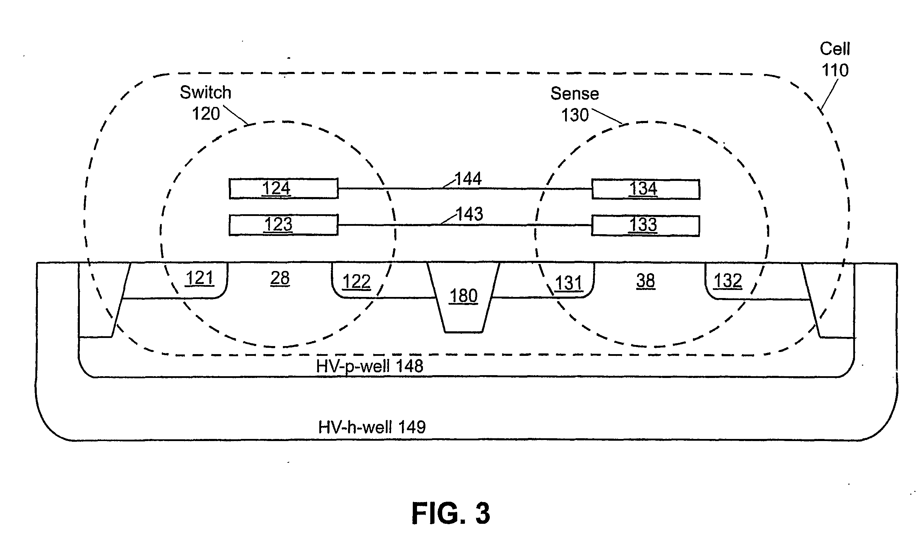

FIG. 3 is a cross-sectional view of the programmable interconnect element cell 110 along vertical axis through both the switch transistor 220 and sense transistor 230 of the programmable interconnect cell 210 of Fig. 2. Programmable interconnect cell 110 comprises high-voltage, triple p-well 148 deposited inside high-voltage n-well 149. All programmable interconnect cells 110 are located in high voltage triple-p-well 148 located in high voltage n-well 149. Programmable interconnect cell 110 includes switch transistor 120 and sense transistor 130 fabricated in high-voltage p-well 148. The source/drain regions 121 and 120 of switch transistor 120, formed by source/drain implants are horizontally isolated from the source/drain regions 131 and 132 of sense transistor 130 by an oxide isolation region 180. Floating gate 123 of switch transistor 120 and floating gate 133 of sense transistor 130 are connected via polysilicon deposit 143. Control gate 124 of switch transistor 120 and control gate 134 of sense transistor 130 are connected via poly-silicon deposit 144.

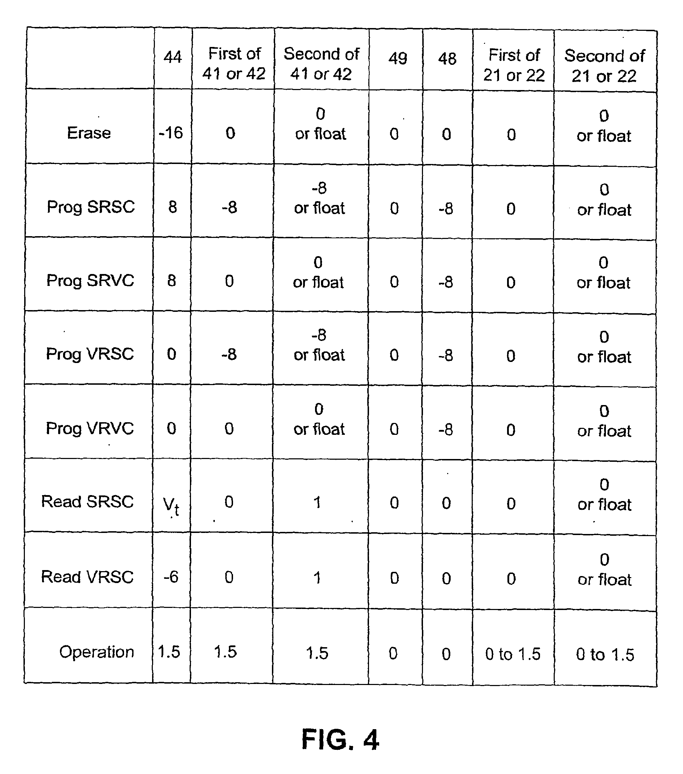

FIG.4 is a table illustrating the respective voltages applied to a switch cell for erasing, programming, reading, and performing the logic-operation of the cell. The erase can be done selective for individual rows or globally for the whole array. Each individual cell can be programmed by selecting rows and columns. Cells can be read individually by selecting rows and columns. During operation of the FPGA, all rows and columns of a part are biased to the same voltage and each individual cell has its individual function in the FPGA circuit, whereby the voltage state of the floating gate of the cell determines whether the cell makes or breaks an interconnect between two nets. Selected rows during erase, programming or read are indicated by the term SR, while unselected rows are indicated by the term UR. Selected columns during programming or read are indicated by the term SC, while unselected columns are indicated by the term UC. The voltages provided in the table are approximate values for switch and sense channel lengths in the order of 0.16um and tunnel oxide thicknesses in the order of 8-10nm.

A cell is erased by erase operation 410 by applying -16 volts to the row line of a cell to be erased, 0 volts to one of either the source column line or the drain column line. 0 volts to a second one of the source or drain column lines 0 volts to the p-well node of the cell, 0 volts to the n-well node of the cell, 0 volts to a first one of the source and drain of the switch transistor, 0 volts or float to the second one of the source and the drain of the switch transistor.

The following operations are the voltages applied to connected cells to program a selected cell or cells. Program operation 420 applies the voltages to cells in a selected row and a selected column. In program operation 420, the following voltages are applied to the cells 8 volts to the row line of a cell to be erased, -8 volts to one of either the source column line or the drain column line, -8 volts or float to a second one of the source or drain column lines, 0 volts to the p-well node of the cell, 0-8 volts to the n-well node of the cell, 0 volts to a first one of the source and drain of the switch transistor, 0 volts or float to the second one of the source and the drain of the switch transistor. Program operation 430 applies voltages to cells in a selected row and an unselected column. In program operation 430, the following voltages are applied to the specified cells: 8 volts to the row line of a cell to be erased, 0 volts to one of either the source column line or the drain column line, 0 volts or float to a second one of the source or drain column lines, 0 volts to the p-well node of the cell, -8 volts to the n-well node of the cell, 0 volts to a first one of the source and drain of the switch transistor, 0 volts or float to the second one of the source and the drain of the switch transistor. Program operation 440 applies voltages to cells in an unselected row and a selected column. In program operation 440, the following voltages are applied to the specified cells: 0 volts to the row line of a cell to be erased, -8 volts to one of either the source column line or the drain column line, -8 volts or float to a second one of the source or drain column lines, 0 volts to the p-well node of the cell -8 volts to the n-well node of the cell, 0 volts to a first one of the source and drain of the switch transistor. 0 volts or float to the second one of the source and the drain of the switch transistor. Program operation 450 applies voltages to cells in an unselected row and an unselected column. In program operation 440, the following voltages are applied to the specified cells: 0 volts to the row line of a cell to be erased, 0 volts to one of either the source column line or the drain column line, 0 volts or float to a second one of the source or drain column lines, 0 volts to the p-well node of the cell, -8 volts to the n-well node of the cell, 0 volts to a first one of the source and drain of the switch transistor, 0 volts or float to the second one of the source and the drain of the switch transistor.

A read operation is performed in the following manner. Read operation 460 applies voltages to the cells in the selected rows and selected columns. Read operation 460 applies the following voltages to the specified cells: Vt to the row line of a cell, 0 volts to one of either the source column line or the drain column line, 1 volt to a second one of the source or drain column lines 0 volts to the p-well node of the cell, 0 volts to the n-well node of the cell, 0 volts to a first one of the source and drain of the switch transistor, 0 volts or float to the second one of the source and the drain of the switch transistor. Read operation 470 applies voltages to the cells in unselected rows and selected columns. Read operation 470 applies the following voltages to the specified cells: -6 volts to the row line of a cell, 0 volts to one of either the source column line or the drain column line, 1 volt to a second one of the source or drain column lines, 0 volts to the p-well node of the cell, 0 volts to the n-well node of the cell, 0 volts to a first one of the source and drain of the switch transistor, 0 volts or float to the second one of the source and the drain of the switch transistor.

Logic operation 480 applies voltages to a cell to perform the programmed operation of the cell. Logic operation 480 applies the following voltages to the specified cells: 1.5 volts to the row line of a cell, 1.5 volts to one of either the source column line or the drain column line, 1.5 volt to a second one of the source or drain column lines, 0 volts to the p-well node of the cell 0 volts to the n-well node of the cell, 0 to 1.5 volts to a first one of the source and drain of the switch transistor, 0 to 1.5 volts or float to the second one of the source and the drain of the switch transistor.

Referring now to FIGS. 1 and 4, the voltages for erasing, programming, reading and the operation of the programmable interconnect cell 10 are illustrated. The n-well node 49 has to be always at a higher or equal voltage than the p-well node 48. This can be most easily achieved by connecting the n-well node 49 to 0V.

For erasing programmable interconnect cell 10, the selected row lines 44 of the programmable interconnect cells 10 are lowered to -16 volts, while the p-well node 49, at least one of the column lines 41 and 42 and at least one of the source 21 and drain 22 regions of the switch 20 are grounded. The second column line 41 or 42 and second source 21 or drain 22 region of the switch transistor 20 can either be also grounded or floating. During this state, electrons from the floating gate node 43 will be removed through the tunneling regions 26 and 36. After erase, when the control-gate voltage will be switched back to 0V, a positive charge will remain on the floating gate node 43. Unselected row-lines stay at 0V during the erase and the floating gate nodes 43 of cells 10 in these rows won't loose electrons and change their state.

To program programmable interconnect cell 10, +8 volts are applied to selected row lines 44 (SR), while all other unselected row lines 44 (UR) are hold at 0V. The p-well node 48 will be biased to -8V. At least one of the column lines 41 and 42 of a selected column (SC) is biased to -8V, while the other of the column lines 41 and 42 can either be biased to -8V or can be floating. At least one of the column lines 41 and 42 of an unselected column (UC) is biased to 0V, while the other of the column lines 41 and 42 of an unselected column (UC) is either biased to 0V or floating. At least one of source region 21 and drain region 22 of each switch 20 in the array has to be biased to 0V by a grounding transistor 60. This is achieved by turning on all transistors 60 by applying a positive voltage of 1.5V to the erase/programming mode signal 73. In this state, electrons will tunnel through tunneling regions 36 from channel 35 of the sense devices 30 to the floating gate of the sense device 33 of selected cells in selected rows and selected columns. Since all channels 35 of unselected columns are at 0V and all control gates of unselected rows are at 0V there is no major tunneling in unselected cells within unselected rows UR or unselected columns UC. After switching back the selected row, selected column and p-well nodes to 0V, there will be a negative charge left on the floating gate node 43 of selected cells, while the state of the floating gate nodes 43 of unselected cells won't have changed during the program operation.

During a read operation, the source column lines 41 of selected columns are connected to 0V, the unselected rows are biased to a negative voltage in the order of -6V in order to turn all sense transistors 30 off independently of their state (initial floating gate voltage). A selected row voltage will be applied. Depending on the initial voltage of the floating gate node 43 of selected cells 10, sense devices 30 will be either turned on or off. An external sense circuit will either bias the drain column line 42 to a voltage in the order of 1V and sense the current or it will force a current into the drain column line 42 of the selected column and sense the voltage at the drain column line 42 and read therefore the state of the cell (programmed or erased, depending on the initial floating gate voltage of the cell). By varying the selected row voltage, the sense trip point of the initial floating gate voltage between the programmed and erased state can be changed.

During the functional operation of the FPGA, all row lines 44 as well as all column lines 41 and 42 can be biased to intermediate voltages like 1.5V in order to optimize the performance of the FPGA.

The described programmable interconnect cell has a typical coupling ratio of 60% between the control gate 44 and the floating gate 43, 35% between the floating gate 43 and the source 21, drain 22 and channel 25 regions of switch transistor 20, 5% between the floating gate 43 and the source 31, drain 32 and channel 35 regions of the sense transistor 30.

## Claims

1. A programmable switching circuit structure (10) comprising:
a control gate potential node (44);
a first floating gate flash memory transistor (20) having a drain (22), a floating gate (23), a control gate (24), and a source (21), said control gate connected to said control gate potential node, and said source connected to a ground potential; and
a second floating gate flash memory transistor (30) having a source (31), a drain (32), a floating gate (33), and a control gate (34), said source electrically connected to a first routing track (41), said drain connected to a second routing track (42), said floating gate (33) connected to said floating gate (23) of said first floating gate flash memory transistor (20), said control gate (34) connected to said control gate potential node (44),
**characterized in that**
said source (21) of said first floating gate flash memory transistor (20) is connected to said ground potential through a grounding transistor (60).

2. The programmable switching circuit structure of claim 1 wherein said drain (22) of said first floating gate flash memory transistor (20) is floating.

3. The programmable switching circuit structure of claim 1 wherein said drain (32) of said first floating gate flash memory transistor (20) is connected to said ground potential through said grounding transistor (60).

## Patentansprüche

1. Aufbau (10) eines programmierbaren Schaltkreises, umfassend:
einen Steuer-Gate-Potentialknoten (44);
einen ersten Flash-Speichertransistor (20) mit schwebendem Gate, der eine Drain (22), ein schwebendes Gate (23), ein Steuer-Gate (24) und eine Source (21) aufweist, wobei das Steuer-Gate mit dem Steuer-Gate-Potentialknoten verbunden ist und die Source mit einem Massepotential verbunden ist; und
einen zweiten Flash-Speichertransistor (30) mit schwebendem Gate mit einer Source (31), einer Drain (32), einem schwebenden Gate (33) und einem Steuer-Gate (34), wobei die Source elektrisch mit einer ersten Leitbahn (41) verbunden ist, wobei die Drain mit einer zweiten Leitbahn (42) verbunden ist, wobei das schwebende Gate (33) mit dem schwebenden Gate (23) des ersten Flash-Speichertransistors (20) mit schwebendem Gate verbunden ist, wobei das Steuer-Gate (34) mit dem Steuer-Gate-Potentialknoten (44) verbunden ist,
**dadurch gekennzeichnet, dass**
die Source (21) des ersten Flash-Speichertransistors (20) mit schwebendem Gate über einen Erdungstransistor (60) mit dem Massepotential verbunden ist.

2. Aufbau eines programmierbaren Schaltkreises nach Anspruch 1, wobei die Drain (22) des ersten Flash-Speichertransistors (20) mit schwebendem Gate schwebt.

3. Aufbau eines programmierbaren Schaltkreises nach Anspruch 1, wobei die Drain (32) des ersten Flash-Speichertransistors (20) mit schwebendem Gate über den Erdungstransistor (60) mit dem Massepotential verbunden ist.

## Revendications

1. Structure de circuit de commutation programmable (10) comprenant :
un noeud de potentiel de grille de commande (44);
un premier transistor de mémoire flash à grille flottante (20) ayant un drain (22), une grille flottante (23), une grille de commande (24) et une source (21), ladite grille de commande étant connectée audit noeud de potentiel de grille de commande, et ladite source étant connectée à un potentiel de masse ; et
un second transistor de mémoire flash à grille flottante (30) ayant une source (31), un drain (32), une grille flottante (33), et une grille de commande (34), ladite source étant électriquement connectée à une première voie de branchement (41), ledit drain étant connecté à une seconde voie de branchement (42), ladite grille flottante (33) étant connectée à ladite grille flottante (23) dudit premier transistor de mémoire flash à grille flottante (20), ladite grille de commande (34) étant connectée audit noeud de potentiel de grille de commande (44),
**caractérisée en ce que**
ladite source (21) dudit premier transistor de mémoire flash à grille flottante (20) est connectée audit potentiel de masse via un transistor de mise à la masse (60).

2. Structure de circuit de commutation programmable selon la revendication 1, dans laquelle ledit drain (22) dudit premier transistor de mémoire flash à grille flottante (20) est flottant.

3. Structure de circuit de commutation programmable selon la revendication 1, dans lequel ledit drain (32) dudit premier transistor de mémoire flash à grille flottante (20) est connecté audit potentiel de masse via ledit transistor de mise à la masse (60).
